# EUROPEAN PATENT SPECIFICATION

(11) **EP 4 004 649 B1**
(45) Date of publication and mention of the grant of the patent: **08.10.2025**
(21) Application number: 20843741.8
(22) Date of filing: 21.07.2020
(51) Int. Cl.: G03F 7/004, G03F 7/20, G03F 7/32

(54) **ORGANOMETALLIC METAL CHALCOGENIDE CLUSTERS AND APPLICATION TO LITHOGRAPHY**
ORGANOMETALLISCHE METALLCHALKOGENID-CLUSTER UND ANWENDUNG IN DER LITHOGRAPHIE
AGRÉGATS DE CHALCOGÉNURE MÉTALLIQUE ORGANOMÉTALLIQUE ET APPLICATION À LA LITHOGRAPHIE

(30) Priority: 22.07.2019 US 201962876842 P
(43) Date of publication of application: 01.06.2022
(73) Proprietor: Inpria Corporation, Corvallis OR 97330 (US)
(72) Inventor: WAMBACH, Truman, Portland, Oregon 97227 (US); EARLEY, William, deceased (US); CARDINAU, Brian J., Corvallis, Oregon 97227 (US)
(74) Representative: dompatent von Kreisler Selting Werner - Partnerschaft von Patent- und Rechtsanwälten mbB
(86) International application number: PCT/US2020/042857
(87) International publication number: WO 2021/016229

(56) References cited:
- WO-A1-2017/211669
- JP-A- H07 133 391
- US-A1- 2012 223 418
- US-A1- 2017 102 612
- US-A1- 2017 102 612
- COSTA G A A ET AL: "THERMAL DECOMPOSITION OF SULFUR-CONTAINING ORGANOTIN MOLECULAR PRECURSORS TO PRODUCE PHASE-PURE SNS", PHYSICAL CHEMISTRY CHEMICAL PHYSICS,, vol. 2, no. 24, 15 December 2000 (2000-12-15), pages 5708 - 5711, XP000976569, ISSN: 1463-9076, DOI: 10.1039/B005795I
- BLECHER AXEL ET AL: "(MeSn) 4 Se 6 , Geometrie und Schwingungsformen eines Adamantan-Gerüstes aus Zinn-Selen-Bindungen / (MeSn) 4 Se 6 , Geometry and Vibrational Modes of an Adamantane Framework Formed by Tin-Selenium Bonds", ZEITSCHRIFT FUR NATURFORSCHUNG - SECTION B JOURNAL OF CHEMICAL SCIENCES, vol. 36, no. 11, 1 November 1981 (1981-11-01), DE, pages 1361 - 1367, XP093024548, ISSN: 0932-0776, DOI: 10.1515/znb-1981-1103
- WRAAGE KARSTEN ET AL: "Synthesis of (RSn) 4 X 6 Adamantanes (X O, S, Se) in Liquid Ammonia ? and in the Two-Phase System Liquid Ammonia/THFa] Regine Herbst-Irmer, [a] Mathias Noltemeyer, [a]", EUROPEAN JOURNAL OF INORGANIC CHEMISTRY, 1 January 1999 (1999-01-01), pages 869 - 872, XP055776013, Retrieved from the Internet <URL:https://chemistry-europe.onlinelibrary.wiley.com/doi/10.1002/%28SICI%291099-0682%28199905%291999%3A5%3C869%3A%3AAID-EJIC869%3E3.0.CO%3B2-2> [retrieved on 20210215], DOI: 10.1002/%28SICI%291099-0682%28199905%291999%3A5%3C869%3A%3AAID-EJIC869%3E3.0.CO%3B2-2!
- ROESKY, HERBERT W. ET AL.: "Synthesis of (RSn)4X6 Adamantanes (X = O, S, Se) in Liquid Ammonia and in the Two‐Phase System Liquid Ammonia/ THF", EUROPEAN JOURNAL OF INORGANIC CHEMISTRY, vol. 1999, no. 5, 1999, pages 869 - 872, XP055776013
- SILVA, A.C.B. ; COSTA, V.C. ; ARDISSON, J.D. ; MAGALHAES, F. ; LAGO, R.M. ; SANSIVIERO, M.T.C.: "Decomposition of the molecular precursor Bu"4Sn"6S"6 on the surface of TiO"2 to prepare semiconductor composite photocatalysts", MATERIALS RESEARCH BULLETIN, ELSEVIER, KIDLINGTON., GB, vol. 45, no. 2, 1 February 2010 (2010-02-01), GB, pages 174 - 180, XP026835602, ISSN: 0025-5408

## Description

### CROSS REFERENCE TO RELATED APPLICATIONS

This application claims priority to co-pending U.S. provisional patent application 62/876,842, filed July 22, 2019 to Cardineau et al., entitled "Organometallic Metal Chalcogenide Clusters and Application to Lithography,".

### FIELD OF THE INVENTION

The invention relates to organometallic photoresist compositions and methods to form photoresist coatings and patterns using the compositions.

### BACKGROUND OF THE INVENTION

In semiconductor manufacturing, materials are patterned to fabricate devices and circuits. These patterned structures are generally formed through an iterative photolithographic process of thin film deposition, radiation exposure, and etch steps to produce a large number of devices in a small area. Advances in the art can involve an increase in device density, which can be desirable to enhance performance.

Thin-film coatings of organic and organometallic compositions can be used as radiation-sensitive photoresists. Radiation can alter the chemical structure and composition of a photoresist and thereby affect its dissolution rate in a selected solvent. A pattern of radiation can be replicated as a latent image in the photoresist coating and then as a patterned photoresist structure by selective dissolution of unexposed and exposed regions. This patterned photoresist structure can then be transferred to the substrate, typically an active or passive device layer, by an etch process.

Liquid developers can be particularly effective for development of the latent image in the photoresist. The substrate can be selectively etched through the resulting windows or gaps in the photoresist layer, or desired materials can be deposited into the exposed windows or gaps. Functional materials such as conductors and dopants can be deposited or incorporated using chemical vapor deposition, physical vapor deposition, ion implantation, and other desired approaches. Ultimately, the patterned photoresist if fully removed. The process is repeated many times to produce additional layers of patterned materials. In semiconductor manufacturing, EUV lithography has been introduced to produce very small feature and device sizes for improved circuit function. This type of lithography has created the need for new families of photoresists that effectively absorb radiation with a wavelength of 13.5 nm.

### SUMMARY OF THE INVENTION

In a first aspect, the invention pertains to a patterning precursor solution comprising an organic solvent; and an organotin cluster composition represented by the formula (RSn)₄X₆ where R is an organic ligand bound to Sn with a metal-carbon bond and X is S or Se, wherein the organic ligand has 1 to 15 carbon atoms , and wherein the precursor solution has a concentration based on tin from 0.0005M to 1M.

In a second aspect, the invention pertains to a structure with a radiation sensitive patterning layer comprising a substrate and a radiation sensitive layer comprising organotin clusters represented by the formula (RSn)₄X₆ wherein R is an organic ligand bound to Sn with a metal-carbon bond, and X is S or Se wherein the radiation sensitive layer has an average thickness from 2 nm to a micrometer, wherein the organic ligand has 1 to 15 carbon atoms.

A third aspect of the disclosure, but not of the invention, pertains to a method for patterning a radiation-sensitive coating of (RSn)₄X₆, the method comprising the steps of irradiating the coated substrate along a selected pattern to form an irradiated structure with regions of irradiated coating and regions of un-irradiated coating and selectively developing the irradiated coating to remove a substantial portion of the un-irradiated regions. The coated substrate generally comprises a coating comprising metal-sulfide clusters or a metal-sulfide network with metal cations having organic ligands with metal-carbon bonds or a metal-sulfideoxide-hydroxide network with metal cations attached to organic ligands via metal-carbon bonds. More specifically, this aspect can be described as a method of patterning a coating, in which the method comprises developing a pattern from a virtual image formed by subjecting a radiation sensitive layer to a radiation pattern to form an irradiated layer. The developing of the pattern can comprise contacting the irradiated layer with an organic solvent to remove substantially an un-irradiated portion of the irradiated layer, in which the radiation sensitive layer is formed with organotin clusters, and wherein irradiation of the radiation sensitive layer results in a material substantially less soluble in organic solvents.

In a further aspect, the invention pertains to a method for forming a radiation sensitive layer suitable for patterning on a substrate surface, the method comprising depositing (RSn)₄X₆ clusters onto a substrate, where X is S or Se and R is an organic ligand bound to Sn with a metal-carbon bond, wherein the organic ligand has 1 to 15 carbon atoms. The depositing step comprises:
1) contacting a solution comprising (RSn)₄S₆ clusters and an organic solvent with the substrate surface, and
   removing the solvent to form a layer of a radiation sensitive coating material;
2) volatilizing the (RSn)₄X₆ clusters, and
   collecting the volatilized clusters on the substrate surface; or
3) performing a reactive deposition of (RSn)₄X₆ using a vapor of (RSn)₄Y₆ and gaseous H₂X, where Y is a halogen atom

### BRIEF DESCRIPTION OF THE DRAWINGS

Fig. 1 is a schematic representation of a (C₄H₉Sn)₄S₆ cluster.
Fig. 2 is a ¹¹⁹Sn{¹H} NMR spectrum of (C₄H₉Sn)₄S₆ in benzene-d₆.
Fig. 3 is a ¹H NMR spectrum of (C₄H₉Sn)₄S₆ in toluene-*d₈*.
Fig. 4 is a ¹³C NMR spectrum of (C₄H₉Sn)₄S₆ in benzene-*d₆*.
Fig. 5 is a ¹¹⁹Sn{¹H} NMR spectrum of (C₄H₇Sn)₄S₆ in chloroform-*d*.
Fig. 6 is a ¹H NMR spectrum of (C₄H₇Sn)₄S₆ in chloroform-*d*.
Fig. 7 is a ¹³C NMR spectrum of (C₄H₇Sn)₄S₆ in benzene-*d₆*.
Fig. 8 is stacked FTIR Spectra of R1 in the solid state (ATR-FTIR) (a) and on a Siwafer (MAPPER-FTIR) (b).
Fig. 9 is a stacked FTIR Spectra of R2 in the solid state (ATR-FTIR) (a) and on a Siwafer (MAPPER-FTIR) (b).
Fig. 10 is a plot of film thickness versus the concentration of (C₄H₉Sn)₄S₆ in the precursor solution. The solvent is toluene.
Fig. 11 is a plot of film thickness versus the concentration of (C₄H₇Sn)₄S₆. The solvent is toluene.
Fig. 12 is a plot of normalized film thickness as a function of developer composition for unexposed films of R1 soaked in the developer composition for 30 seconds.
Fig. 13 is a plot of normalized film thickness as a function of developer composition for UV exposed films of R1 soaked in the developer composition for 30 seconds.
Fig. 14 is a plot of normalized film thickness as a function of developer composition for unexposed films of R2 soaked in the developer composition for 30 seconds.
Fig. 15 is a plot of normalized film thickness as a function of developer composition for UV exposed films of R2 soaked in the developer composition for 30 seconds
Fig. 16 is a plot of contrast curves generated using a formulation of R1 and various process conditions.
Fig. 17 is a set of contrast curves generated using a formulation of R2 and various process conditions.

### DETAILED DESCRIPTION OF THE INVENTION

Organo tin clusters provide improved characteristics for high-resolution radiation-based patterning, and the tetramers of tin described herein are appropriately processable for application in EUV lithography. The clusters form as tetrameric species with bridging thio groups and appended alkyl groups conferring cluster stability. The tin tetramers, amorphous solids at room temperature, are soluble in suitable organic liquids. Patterning formulations are described based on dissolution of the tin tetramers in organic solvents and deposition of uniform and functional coatings on suitable substrates. EUV patterning with desirable properties is demonstrated.

The fabrication of semiconductor circuits and devices has involved a regular reduction in critical dimensions over each successive generation. As these dimensions shrink, new materials and methods can be called upon to meet the demands of processing and patterning smaller and smaller feature sizes. Patterning generally involves selective exposure of a thin layer of a radiation sensitive material (photoresist) to form a pattern that is then transferred into subsequent layers and functional materials. Metal-based resists offer a new class of material that is especially suitable for providing good absorption of extreme UV light and electron beam radiation, while simultaneously providing very high etch contrast.

The use of alkyl substituted metal coordination and cluster compounds that form oxo hydroxo networks have proven to be extremely promising patterning materials in high performance radiation-based patterning, especially for extreme ultraviolet patterning. Alkyl metal patterning compositions are described, for example, in U.S. patent 9,310,684 to Meyers et al., entitled "Organometallic Solution Based High Resolution Patterning Compositions,". Refinements of these organometallic compositions for patterning are described in U.S. patent 10,642,153 B1 to Meyers et al., entitled "Organometallic Solution Based High Resolution Patterning Compositions and Corresponding Methods," and 10,228,618 B1 to Meyers et al., entitled "Organotin Oxide Hydroxide Patterning Compositions, Precursors, and Patterning,". The organo tin clusters described herein involve replacement of the oxo hydroxo ligands with sulfide ligands, and the results herein indicate that the sulfide compositions can provide similar desirable patterning results for EUV patterning.

A desirable organometallic precursor solution for high-resolution EUV lithography exhibits a shelf life supporting commercial distribution, adheres to preferred substrates, produces uniform and smooth thin-film coatings, and responds to radiation exposure with high sensitivity. Desirable compositions of these solutions can comprise organometallic metal sulfides of the type (RSn)₄S₆ dissolved in an organic solvent, wherein R is a hydrocarbyl ligand with 1 to 15 C atoms that is linked to tin via a Sn-C bond. In embodiments of specific interest, the organo tin sulfides may be dissolved in polar solvents such as tetrahydrofuran (THF) or combinations of THF and anisole, which serve as a vehicle to uniformly coat substrates by spin coating and related methods. In further embodiments, these coatings can be exposed with patterns of UV or EUV light to induce chemical changes that make the exposed regions more resistant than unexposed regions to dissolution in an organic developer. This behavior, wherein the exposed photoresist remains on the substrate after development, characterizes a negative-tone material.

Tin clusters with alkyl and bridging dianionic chalcogenides (S, Se) have been synthesized previously to form an adamantane structure. Examples of synthesis and characterization of (RSn)₄X₆ (X=S or Se) are found in the following articles:
R = methyl, n-butyl, t-butyl, phenyl. G. A. Costa, M. C. Silva, G. M. de Lima, R. M. Logo, M. T. C. Sansiviero, Thermal decomposition of sulfur-containing organotin molecular precursors to produce pure-phase SnS. Phys. Chem. Chem. Phys. 2, 5708-5711 (2000).
R = (Me₃Si)₃C. K. Wraage, T. Pape, R. Herbst-Irmer, M. Noltemeyer, H.-G. Schmidt, H. W. Roesky, Synthesis of (RSn)4X6 adamantanes (X = O, S, Se) in liquid ammonia in the two-phase system liquid ammonia/THF. European Journal of Inorganic Chemistry 5, 869-872 (1999).
R = 4-(CH₂=CH)-C₆H₄. N. Rosemann, J. P. Eußner, A. Beyer, S. W. Koch, K. Volz, S. Dehnen, S. Chatterjee, A highly efficient directional molecular white-light emitter driven by a continuous-wave laser diode. Science 352, 1301-1304 (2016).

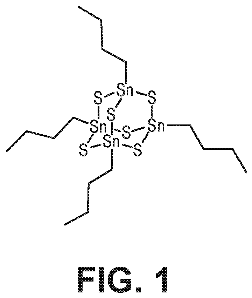

The (RSn)₄(S,Se)₆ clusters have four metal (metalloid) atoms with one organic ligand, which is linked to the metal (metalloid) center through metal (metalloid) - carbon bond. Fig. 1 illustrates the structure of one embodiment of an organo tin sulfide cluster. In some embodiments, the clusters contain dianionic chalcogen (e.g., thio) ligands shared between two Sn centers. The tin-carbon bonds are sensitive to scission by radiation, which can induce differential dissolution rates and enable the desired radiation-based patterning. Alternatively, the R groups may contain unsaturated alkenyl moieties that can crosslink via radiation exposure. Both processes - initial bond scission and crosslinking - are expected to produce negative-tone lithographic patterns based on changes in solubility of the irradiated material. Nonaqueous solutions formed with the clusters provide coating compositions that are promising with respect to improved precursor solubility, coating quality, and sensitivity relative to other radiation-based organometallic patterning materials.

### Synthesis of Clusters and Formation of Coating Solutions

(RSn)₄S₆ compositions can be made by direct reaction of a monoorgano tin trichloride with sodium sulfide in THF. Examples describe the synthesis of derivatives with R = butyl and butenyl. Reagents are mixed in a 4:6 stoichiometric ratio according to the following reaction:

4 RSnCl₃ + 6 Na₂S = (RSn)₄S₆ + 12 NaCl

A solution of RSnCl₃ in THF is added to a cooled solution (- 78 °C) of Na₂S in THF to affect the reaction. Hydrogen sulfide (H₂S) can be used in place of sodium sulfide. Filtration removes the precipitated solid NaCl. Similar reactions can be performed with Na₂Se to form the selenide cluster compounds (RSn)₄Se₆, and the following discussion can correspondingly apply to the selenides analogously to the discussion of the sulfides and can be considered to be correspondingly explicitly disclosed. Evaporation of the solvent then produces solid (RSn)₄S₆, which can then be dissolved in CH₂Cl₂ and passed through a silica plug to remove impurities. Subsequent evaporation of the solvent produces a purified product, which can be ground under pentane and recovered by filtration to form a free flowing white solid. The Examples below demonstrate the synthesis with R = n-butyl (C₄H₉) or with R = n-butenyl (C₄H₇). Some monoorgano tin trichloro precursors compounds are commercially available, while others can be synthesized using available protocols, with one example discussed in the Examples.

An R (organo) group can be a hydrocarbyl group, such as a linear, branched, (i.e., secondary or tertiary at the metal bonded carbon atom) or cyclic hydrocarbyl group. Each R group individually generally has from 1 to 15 carbon atoms with 3 to 15 carbon atoms for the secondary-bonded carbon atom and 4 to 15 carbon atoms for the tertiary-bonded carbon atom embodiments, for example, methyl, ethyl, propyl, butyl, and branched alkyl. In particular, branched alkyl ligands are desirable where the compound can be represented in another representation by R¹R²R³CSnX₃, where R¹ and R² are independently an alkyl group with 1-10 carbon atoms, and R³ is hydrogen or an alkyl group with 1-10 carbon atoms. In some embodiments R¹ and R² can form a cyclic alkyl moiety, and R₃ may also join the other groups in a cyclic moiety. Suitable branched alkyl ligands can be, for example, isopropyl (R¹ and R² are methyl and R³ is hydrogen), tert-butyl (R¹, R²and R³ are methyl), tert-amyl (R¹ and R² are methyl and R³ is -CHCH₃), sec-butyl (R¹ is methyl, R² is -CHCH₃, and R³ is hydrogen), cyclohexyl, cyclopentyl, cyclobutyl, and cyclopropyl. Examples of suitable cyclic groups include, for example, 1-adamantyl (-C(CH₂)₃(CH)₃(CH₂)₃ or tricyclo(3.3.1.13,7) decane bonded to the metal at a tertiary carbon) and 2-adamantyl (-CH(CH)₂(CH₂)₄(CH)₂(CH₂) or tricyclo(3.3.1.13,7) decane bonded to the metal at a secondary carbon). In other embodiments hydrocarbyl groups may include aryl, or alkenyl groups, for example benzyl, allyl, or alkynyl groups. In other embodiments the hydrocarbyl ligand R may include any group consisting solely of C and H, and containing 1-15 carbon atoms. For example: linear or branched alkyl (ⁱPr, ^{t}Bu, Me, ⁿBu), cyclo-alkyl (cyclo-propyl, cyclo-butyl, cyclo-pentyl), olefinic (alkenyl, aryl, allylic), or alkynyl groups, or combinations thereof. In further embodiments suitable R-groups may include hydrocarble groups substituted with hetero-atom functional groups including cyano, thio, silyl, ether, keto, ester, or halogenated groups or combinations thereof.

The solid (RSn)₄S₆ product can be dissolved in suitable solvents at room temperature or by gentle heating (35 - 65 °C) to produce a coating composition. The clusters are generally soluble in a broad range of organic solvents. For example, it can be dissolved in organic solvents such as benzene, toluene, chlorotoluene, 1,1,2-trichloroethane, tetrahydrofuran (THF), anisole, and THF-anisole mixtures, mixtures thereof, or the like. In general, organic solvent selection can be influenced by solubility parameters, volatility, flammability, toxicity, viscosity, and chemical interaction with the substrate. THF and THF-anisole mixtures in particular enable deposition of smooth and uniform (RSn)₄S₆ coatings. As a photoresist for radiation-based patterning, the precursor solution can generally comprise from 0.0005 M to 1.0 M tin atoms, in further embodiments from about 0.00025 M to about 0.6 M tin atoms, and in additional embodiments from about 0.01 M to about 0.40 M tin atoms. The solutions can be applied to the substrate by spin coating or other suitable technique. A person of ordinary skill in the art will recognize that additional ranges of concentrations within the explicit ranges above are contemplated and are within the present disclosure. In general, precursor solutions can be well mixed using appropriate mixing equipment for the volume of material being formed. Suitable filtration can be used to remove contaminants, small particles, and other components that do not appropriately dissolve.

A coating material can be formed through deposition and subsequent processing of the precursor solution onto a selected substrate. A substrate generally presents a surface onto which the coating material can be deposited, and the substrate may comprise a plurality of layers in the surface relates to the upper most layer. Suitable substrate surfaces can comprise any reasonable material. Some substrates of particular interest include, for example, silicon wafers, silica substrates, other inorganic materials such as ceramics, organic polymers, composites thereof and combinations thereof across a surface and/or in layers of the substrate. Wafers, such as relatively thin cylindrical structures, can be convenient, although any reasonably shaped structure can be used. Polymer substrates or substrates with polymer layers on non-polymer structures can be desirable for certain applications based on lithographic performance or substrate cost and flexibility, and suitable polymers can be selected based on the relatively low processing temperatures that can be used for the processing of the patternable materials described herein. Suitable polymers can include, for example, polycarbonates, polyimides, polyesters, polyalkenes, co-polymers thereof, or mixtures thereof. In general, it is desirable for the substrate to have a flat surface, especially for high resolution applications. In specific embodiments, however, the substrate may possess substantial topography, where the resist coating is intended to fill or planarize features for particular patterning applications.

### Coating Formation

In general, any suitable solution or vapor coating process can be used to deliver the precursor to the substrate. Suitable coating approaches include, for example, spin coating, spray or aerosol coating, dip coating, slot-die coating, knife-edge coating, printing approaches, such as ink jet printing and screen printing, and vapor deposition, such as deposition of volatilized compound, chemical vapor deposition (CVD) or atomic layer deposition (ALD). Some of these coating approaches form patterns of coating material during the coating process, although the resolution available currently from printing or the like has a significantly lower resolution than available from radiation-based patterning as described herein. The thickness of the resulting deposited layer can be adjusted using the coating parameters and adjusting the solution concentration. The dry coating thickness is a function of the wet coating thickness and the concentration.

If patterning is performed via radiation-based lithography, spin coating can be a desirable approach to cover the substrate uniformly, although this uniformity can be compromised by formation of a bead near the edge of the substrate. In some embodiments, a substrate can be spun at rates from about 500 rpm to about 10,000 rpm, in further embodiments from about 1000 rpm to about 7500 rpm and in additional embodiments from about 2000 rpm to about 6000 rpm. The spin speed can be adjusted to obtain a desired coating thickness. The spin coating can be performed for times from about 5 seconds to about 5 minutes and in further embodiments from about 15 seconds to about 2 minutes. An initial low speed spin, e.g., at 50 to 250 rpm, can be used to perform an initial bulk spreading of the composition across the substrate. A back-side rinse, edge bead removal step, or the like can be performed with a suitable organic solvent to remove any edge bead. A person of ordinary skill in the art will recognize that additional ranges of spin coating parameters within the explicit ranges are contemplated and are within the present disclosure. Clearing of the bead edge for organometallic patterning materials is described in U.S. patent 10,627,719 to Waller et al., entitled "Methods Of Reducing Metal Residue In Edge Bead Region From Metal-Containing Resists,".

With respect to vapor based deposition, some of the compounds can be heated in an inert atmosphere to achieve a suitable vapor pressure for forming a desired thin coating. The substrate surface can be placed in a suitable nearby location to receive the vapor of the compound. Heating to form the volatile compounds can be greater than 400°C and in some embodiments from 450°C to 1000°C. A person of ordinary skill in the art will recognize that additional ranges of temperature within the explicit ranges above are contemplated and are within the present disclosure. Alternatively or additionally, vapor deposition can be performed using chemical vapor deposition or atomic layer deposition. Atomic layer deposition is basically a step-wise CVD deposition in which a layer of organo tin trihalide is deposited and then reacted with a gas of hydrogen sulfide (or selenide), which is then repeated to obtain a desired coating thickness. These reactive deposition approaches can be achieved using a vapor of the organo tin trihalides along with hydrogen sulfide (or hydrogen selenide) which is a gas. The deposition approaches can be performed in a suitable CVD reaction chamber or the like.

The coating process itself can result in the evaporation of a portion of the solvent since many coating processes form droplets or other forms of the coating material with larger surface areas and/or movement of the solution that stimulates evaporation. The loss of solvent tends to increase the viscosity of the coating material as the concentration of the species in the material increases. An objective during the coating process can be to remove sufficient solvent to stabilize the coating material for further processing. Coating species may react with air, hydrolyze, or condense during coating or subsequent heating to form a chemically modified coating material.

Empirical evaluation of the resulting coating material properties generally can be performed to select processing conditions that are effective for the patterning process. While heating may not be needed for successful application of the process, it can be desirable to heat the coated substrate to speed the processing and/or to increase the reproducibility of the process and/or to facilitate vaporization of volatile byproducts. In embodiments in which heat is applied to remove solvent in a pre-exposure bake, the coating material can be heated to temperatures from about 45 °C to about 250 °C and in further embodiments from about 55 °C to about 225 °C. The heating for solvent removal can generally be performed for at least about 0.1 minute, in further embodiments from about 0.5 minutes to about 30 minutes and in additional embodiments from about 0.75 minutes to about 10 minutes. Final film thickness is determined by baking temperatures and times as well as the initial concentration of the precursor. Examples demonstrate a linear relationship between film thickness and precursor concentration. A person of ordinary skill in the art will recognize that additional ranges of heating temperature and times within the explicit ranges above are contemplated and are within the present disclosure. As a result of the heat treatment, potential hydrolysis, and densification of the coating material, the coating material can exhibit an increase in index of refraction and in absorption of radiation without significant loss of dissolution rate contrast.

The deposition process determines the wet coating thickness. For further processing, the solvent is generally removed to leave a solid layer as a coating on the substrate. The solution concentration and process conditions influence the dry coating thickness, which can be selected to achieve desired patterning properties. The average dry coating thickness can be from about 2 nm to about 1000 nm, in further embodiments from about 3 nm to about 300 nm and in additional embodiments from about 3 nm to about 80 nm. For vapor deposition described below, the coating thickness can be correspondingly adjusted through process conditions to achieve a desired layer thickness for the coating. A person of ordinary skill in the art will recognize that additional average thickness ranges within the explicit ranges above are contemplated and are within the present disclosure.

### Patterning

Following drying and potential hydrolysis, the coating material can be finely patterned using radiation. As noted above, the composition of the precursor solution and thereby the corresponding coating material can be designed for sufficient absorption of a desired form of radiation, with a particular interest with respect to EUV radiation. The absorption of the radiation results in energy that can break the bonds between the metal and alkyl ligands so that at least some of the alkyl ligands are no longer available to stabilize the material such that tin sulfide/selenide forms. Alternatively, absorption of high energy radiation may initiate a coupling (polymerization) reaction between unsaturated centers in R ligands bound to neighboring tin sulfide/selenide clusters. With alkyltin ligands for sulfide clusters, the modifications caused by the radiation are potentially less clear, but the compositions are observed to provide good patterning properties. Radiolysis products, including alkyl ligands or other fragments may diffuse out of the film, or not, depending on process variables and the identity of such products. With the absorption of a sufficient amount of radiation, the exposed coating material condenses, i.e. forms an enhanced cross-linked network, which may involve additional water absorbed from the ambient atmosphere. The radiation generally can be delivered according to a selected pattern. The radiation pattern is transferred to a corresponding pattern or latent image in the coating material with irradiated areas and un-irradiated areas. The irradiated areas comprise chemically altered coating material, and the un-irradiated areas comprise generally the as-formed coating material. Very smooth edges can be formed upon development of the coating material with the removal of the un-irradiated coating material or alternatively with selective removal of the irradiated coating material.

Radiation generally can be directed to the coated substrate through a mask or a radiation beam can be controllably scanned across the substrate. In general, the radiation can comprise electromagnetic radiation, an electron beam (beta radiation), or other suitable radiation. In general, electromagnetic radiation can have a desired wavelength or range of wavelengths, such as visible, ultraviolet, extreme ultraviolet, or X-ray radiation. The resolution achievable for the radiation pattern is generally dependent on the radiation wavelength, and a higher resolution pattern generally can be achieved with shorter wavelength radiation. Thus, it can be desirable to use ultraviolet, extreme ultraviolet, or X-ray radiation, or electron-beam irradiation to achieve particularly high-resolution patterns.

Following International Standard ISO 21348 (2007), ultraviolet light extends between wavelengths of longer than or equal 100 nm and shorter than 400 nm. A krypton fluoride laser can be used as a source for 248 nm ultraviolet light. The ultraviolet range can be subdivided in several ways under accepted Standards, such as extreme ultraviolet (EUV) from longer than or equal 10 nm to shorter than 121 nm and far ultraviolet (FUV) from longer than or equal to 122 nm to shorter than 200 nm. A 193 nm line from an argon fluoride laser can be used as a radiation source in the FUV. EUV light at 13.5 nm has been used for lithography, and this light is generated from a Xe or Sn plasma source excited using high energy lasers or discharge pulses. Soft X-rays can be defined from longer than or equal 0.1 nm to shorter than 10 nm.

The amount of electromagnetic radiation can be characterized by a fluence or dose, which is defined by the integrated radiative flux over the exposure time. Generally, suitable EUV radiation fluences can be from about 1 mJ/cm² to about 175 mJ/cm², in further embodiments from about 2 mJ/cm² to about 150 mJ/cm², and in further embodiments from about 3 mJ/cm² to about 125 mJ/cm². A person of ordinary skill in the art will recognize that additional ranges of radiation fluences within the explicit ranges above are contemplated and are within the present disclosure.

Based on the design of the coating material, a large contrast of material properties can be induced between the irradiated and unirradiated regions of the coating material. For embodiments in which a post irradiation heat treatment is used, the post-irradiation heat treatment can be performed at temperatures from about 45 °C to about 250 °C, in additional embodiments from about 50 °C to about 190 °C and in further embodiments from about 60 °C to about 175 °C. The post exposure heating can generally be performed for at least about 0.1 minute, in further embodiments from about 0.5 minutes to about 30 minutes and in additional embodiments from about 0.75 minutes to about 10 minutes. A person of ordinary skill in the art will recognize that additional ranges of post-irradiation heating temperature and times within the explicit ranges above are contemplated and are within the present disclosure. This high contrast in material properties further facilitates the formation of high-resolution lines with smooth edges in the pattern following development as described in the following section.

For the negative tone imaging, the developer can be an organic solvent, such as the solvents used to form the precursor solutions. In general, developer selection can be influenced by solubility parameters with respect to the coating material, both irradiated and non-irradiated, as well as developer volatility, flammability, toxicity, viscosity and potential chemical interactions with other process material. In particular, suitable developers include, for example, ethyl lactate, ethers (e.g., tetrahydrofuran (THF), dioxane, anisole), ketones (e.g., 2-pentanone, 3-pentanone, hexanone, 2-heptanone, octanone), and the like. Examples demonstrate that THF and THF-anisole mixtures are preferred developers. The development can be performed for about 5 seconds to about 30 minutes, in further embodiments from about 8 seconds to about 15 minutes and in addition embodiments from about 10 seconds to about 10 minutes. A person of ordinary skill in the art will recognize that additional ranges within the explicit ranges above are contemplated and are within the present disclosure.

In addition to the primary developer composition, the developer can comprise additives to facilitate the development process. Suitable additives may include, for example, viscosity modifiers, solubilization aids, or other processing aides. If the optional additives are present, the developer can comprise no more than about 20 weight percent additive, in further embodiments no more than about 10 weight percent additive, and in further embodiments no more than about 5 weight percent additive. A person of ordinary skill in the art will recognize that additional ranges of additive concentrations within the explicit ranges above are contemplated and are within the present disclosure.

With a weaker developer in which the coating has a lower development rate, a higher temperature development process can be used to increase the rate of the process. With a stronger developer, the temperature of the development process can be lower to reduce the rate and/or control the kinetics of the development. In general, the temperature of the development can be adjusted between the appropriate values consistent with the volatility of the solvents. Additionally, developer with dissolved coating material near the developer-coating interface can be dispersed with ultrasonication during development.

The developer can be applied to the patterned coating material using any reasonable approach. For example, the developer can be sprayed onto the patterned coating material. Also, spin coating can be used. For automated processing, a puddle method can be used involving the pouring of the developer onto the coating material in a stationary format. If desired spin rinsing and/or drying can be used to complete the development process. Suitable rinsing solutions include, for example, ultrapure water, aqueous tetra alkyl ammonium hydroxide, methyl alcohol, ethyl alcohol, propyl alcohol and combinations thereof. After the image is developed, the coating material is disposed on the substrate as a pattern.

After completion of the development step, the coating material can be heat treated to further condense the material and to further dehydrate, densify, or remove residual developer from the coating. This heat treatment can be particularly desirable for embodiments in which the coating material is incorporated into the ultimate device, although it may be desirable to perform the heat treatment for some embodiments in which the coating material is used as a resist and ultimately removed if the stabilization of the coating material is desirable to facilitate further patterning. In particular, the bake of the patterned coating material can be performed under conditions in which the patterned coating material exhibits desired levels of etch selectivity. In some embodiments, the patterned coating material can be heated to a temperature from about 80 °C to about 600 °C, in further embodiments from about 175 °C to about 500 °C and in additional embodiments from about 200 °C to about 400 °C. The heating can be performed for at least about 1 minute, in other embodiment for about 2 minutes to about 1 hour, in further embodiments from about 2.5 minutes to about 25 minutes. The heating may be performed in air, vacuum, or an inert gas ambient, such as Ar or N₂. A person of ordinary skill in the art will recognize that additional ranges of temperatures and time for the heat treatment within the explicit ranges above are contemplated and are within the present disclosure. Likewise, non-thermal treatments, including blanket UV exposure, or exposure to an oxidizing plasma such as O₂ may also be employed for similar purposes.

Wafer throughput is a substantially limiting factor for implementation of EUV lithography in high-volume semiconductor manufacturing, and it is directly related to the dose required to pattern a given feature. However, while chemical strategies exist to reduce imaging dose, a negative correlation between the imaging dose required to print a target feature, and feature size uniformity (such as LWR) is commonly observed for EUV photoresists at feature sizes and pitches < 50 nm, thereby limiting final device operability and wafer yields. Patterning capability can be expressed in terms of the dose-to-gel value. Imaging dose requirements can be evaluated by forming an array of exposed pads in which the exposure time is stepped from pad to pad to change the dosing of the exposure. The film can then be developed, and the thickness of the remaining resist can be evaluated for all of the pads, for example, using spectroscopic ellipsometry. The measured thicknesses can be normalized to the maximum measured resist thickness and plotted versus the logarithm of exposure dose to form characteristic curves. The maximum slope of the normalized thickness vs log dose curve is defined as the photoresist contrast (γ) and the dose value at which a tangent line drawn through this point equals 1 is defined as the photoresist dose-to-gel, (Dg). D₀ corresponds to the onset dose for initial increase in film thickness for a negative-tone resist. In this way common parameters used for photoresist characterization may be approximated following Mack, C. (Fundamental Principles of Optical Lithography, John Wiley & Sons, Chichester, U.K; pp 271-272, 2007.)

### EXAMPLES

### Example 1. Preparation of Precursor (C₄H₉Sn)₄S₆

This example presents the synthesis of an n-butyltin sulfide cluster composition.

Sodium sulfide (17.9g, 230 mmol, Alfa Aesar, 95%) was added to a round-bottom flask (500 mL) equipped with a magnetic stirrer. THF (150 mL, Aldrich) was then added to the flask to dissolve the sodium sulfide. The resulting solution was cooled to -78 °C; a solution of n-butyltin trichloride (38.1 g, 135.0 mmol, Aldrich, 95%) in THF (60 mL) was then added dropwise to it. The mixed solutions formed a slurry that was stirred at room temperature for 16 h and then filtered through a short plug of Celite^{®}. The resulting filtrate was dried under vacuum and subsequently dissolved in dichloromethane. The solution was filtered through a silica plug and further eluted with dichloromethane. The solvent and other volatile components were removed under vacuum to produce an amorphous solid, which was triturated with pentane, collected by filtration, and dried under vacuum to yield (C₄H₉)₄Sn₄S₆ (21.02 g, 69.5%) as a white amorphous solid.

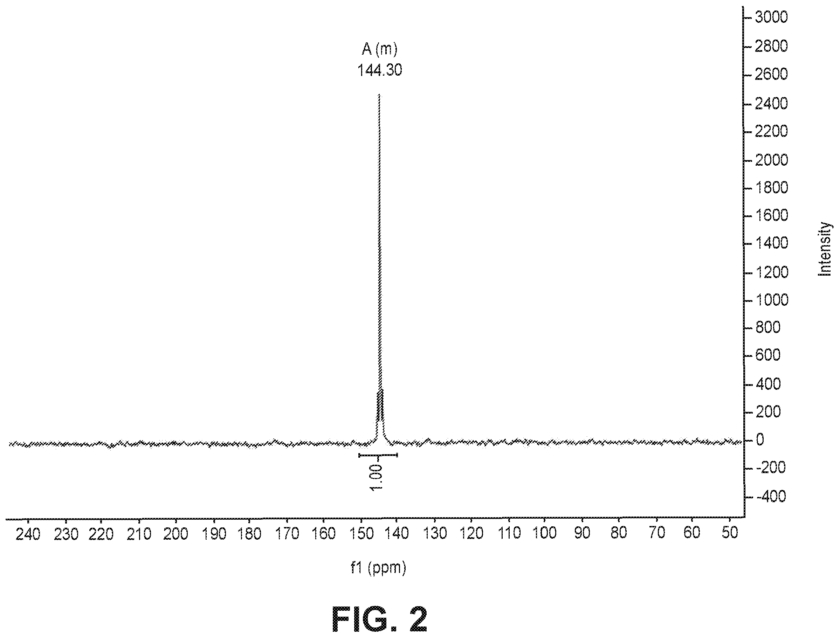

Fig. 2 shows the ¹¹⁹Sn{¹H} NMR spectrum of (C₄H₉Sn)₄S₆ in benzene-d₆. The spectrum shows a single peak at -144.3 ppm due to the four tin atoms with equivalent bonding environments. The benzene-d₆ solvent had a resonance at -149 MHz.

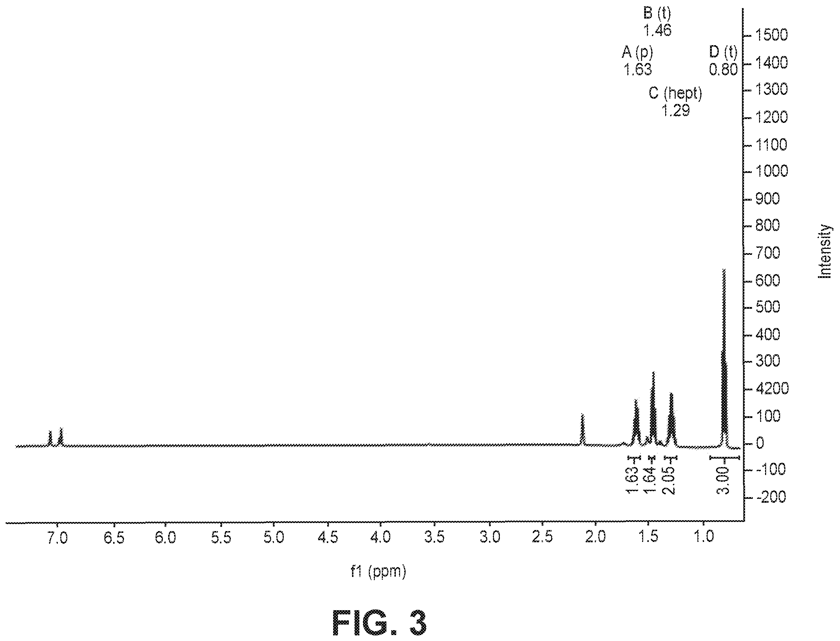

Fig. 3 shows the ¹H NMR spectrum of (C₄H₉Sn)₄S₆ in toluene-d₈. The spectrum shows a plurality of resonances (*J* = 7.6 Hz) at -1.63 ppm and a heptet at -1.29 ppm (*J*= 7.2 Hz). The integration ratio as 1:1, with each resonance pattern corresponding to eight (8) -CH₂hydrogens of the butyl ligands. The spectrum shows a triplet (*J* = 7.8 Hz) at -1.46 ppm, consistent with the -CH₂- protons closest to the tin atoms and a triplet (*J* = 7.3 Hz) at -0.80 ppm, consistent with the -CH₃ protons. The integration ratio was 1:1.5, corresponding to the 8 total alpha -CH₂- protons and twelve total -CH₃ protons. The toluene-d₈ solvent had a resonance at -500 MHz.

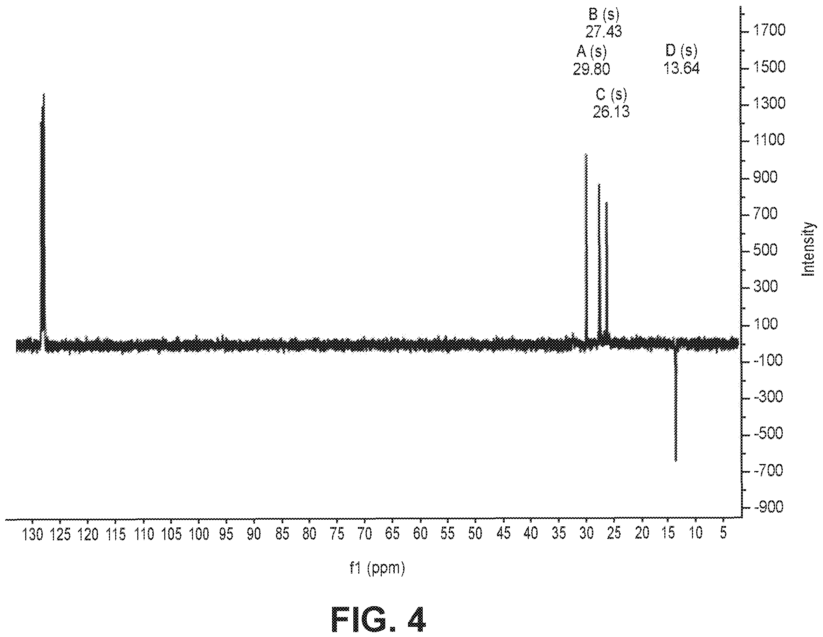

Fig. 4 shows the ¹³C NMR spectrum of (C₄H₉Sn)₄S₆ in benzene-d₆. The spectrum shows singlets at -29.80 ppm, -27.43 ppm, and -26.13 ppm, each corresponding to a -CH₂- carbon in the butyl ligands. The spectrum shows a singlet at -13.64 ppm, corresponding to the -CH₃ carbon. The benzene-d₆ solvent had a resonance at -101 MHz.

The characterization confirmed the synthesis of a purified n-butyltin cluster composition product, R1

### Example 2: Preparation of Precursor (C₄H₇Sn)₄S₆

This example presents the synthesis of an n-butenyltin cluster composition.

n-Butenyl tin trichloride was prepared by reaction of one-part (C₄H₇)₄Sn and three parts SnCl₄. The procedures are adapted methods from U.S. Patent #2,873,288 and Schumann, Herbert; Aksu, Yilmaz; Wassermann, Birgit C. Journal of Organometallic Chemistry 691(8), 1703-1712 (2006).

Synthesis of (C₄H₇)₄Sn.₄ (5.4 g, 0.22 mol) in THF (400 ml) was carefully prepared through dropwise addition of SnCl₄ to a cooled (-78°C) solution of THF. *(Caution: considerable gas evolution can occur on addition of SnCl₄ to THF, likely attributable to the formation of HCl(g) from hydrolysis of SnCl₄.)* The previously prepared 3-butenyl Grignard solution was added dropwise to the cooled solution of SnCl₄. After complete addition, the solution was warmed to room temperature and stirred for 12 hours. The solution was then concentrated to half its volume and pentane (200 mL) added. The resulting slurry was filtered thru Celite^{®} and concentrated under vacuum. The residue was placed on a short plug of silica gel (200 g) and eluted with pentane. Removal of the volatiles under vacuum yielded the desired product (C₄H₇)₄Sn (49 g, 51%) as a colorless liquid with confirmation by NMR as follows. ¹¹⁹Sn NMR (186 MHz, Chloroform-d) δ -5.64 (s, 1Sn). ¹H NMR (500 MHz, Chloroform-*d*) δ 5.87 (ddt, *J =* 16.6, 10.1, 6.3 Hz, 4H, *Sn-butenyl* =*CH* ), 5.01 (dq, *J* = 17.1, 1.8 Hz, 4H, *Sn-butenyl=CH*), 4.93 (dq, *J* = 10.1, 1.5 Hz, 4H, *Sn-butenyl=CH*), 2.37 - 2.18 (m, 8H, *Sn-butenyl-CH₂*), 1.04 - 0.87 (m, 8H, *Sn-butenyl-CH₂).*

Synthesis of n-butenyl tin trichloride by reaction of (C₄H₇)₄Sn and SnCl₄.₄H₇)₄Sn (10 g, 29.5 mmol) and dissolved via dropwise addition of toluene (25 ml). SnCl₄ (25.13g, 96.5 mmol) was added dropwise. The resulting mixture was stirred at room temperature for 2 hours and then Cl₂Pt(PPh₃)₂ (0.01 g, 0.013 mmol) was added. The mixture was then heated for approximately 12 hours at 110 °C, until ¹¹⁹Sn NMR spectroscopy indicated complete conversion to the desired product. The mixture cooled to room temperature, and the mixture filtered through a short plug of silica, which was rinsed three times with 20-mL portions of toluene. The filtrate was collected, and the volatiles removed under vacuum. The product was distilled to give a colorless oil with a boiling point 40 - 75 °C and a vapor pressure of 133 - 40 Pa (1-0.3 torr), corresponding to the desired product (C₄H₇)SnCl₃ (24.71g, 88.2 mmol, 68.5% yield) with confirmation by NMR as follows. ¹¹⁹Sn NMR (149 MHz, Chloroform-*d* δ 2.71 (s, 1Sn). ¹H NMR (400 MHz, Chloroform-*d*) δ 5.92 (ddt, *J =* 16.7, 10.1, 6.4 Hz, 1H, *Sn-butenyl=CH₂*), 5.27 (q, *J =* 1.4 Hz, 1H, *Sn-butenyl=CH*)*,* 5.25 - 5.20 (m, 1H, *Sn-butenyl-CH*), 2.67 (qt, *J =* 6.8, 1.4 Hz, 2H, *Sn-butenyl-CH₂*), 2.45 (t, *J* = 7.2 Hz, 2H, *Sn-butenyl-CH₂*)*.*

Synthesis of (C₄H₇Sn)₄S₆. Sodium sulfide (17.9 g, 230 mmol, Alfa Aesar, 95%) was added to a round-bottom flask (500 mL) equipped with a magnetic stirrer. THF (150 mL) was then added to the flask and the resulting solution was cooled to -78 °C. A solution of (C₄H₇)SnCl₃ (37.8 g, 135.0 mmol) in THF (60 mL) was added dropwise to the cooled sodium sulfide solution. The resulting slurry was stirred at room temperature for 16 h and filtered through a short plug of Celite^{®}. The filtrate was dried under vacuum and dissolved in dichloromethane. The resulting solution was filtered through a silica plug. The silica plug was rinsed with additional dichloromethane, and the resulting dichloromethane solution combined with the initial filtrate. The solvent and volatile components were removed under vacuum to give an amorphous solid, which was triturated with pentane, collected by filtration, and dried under vacuum to yield (C₄H₇Sn)₄S₆ (18.0 g, 60.1%) as a white solid.

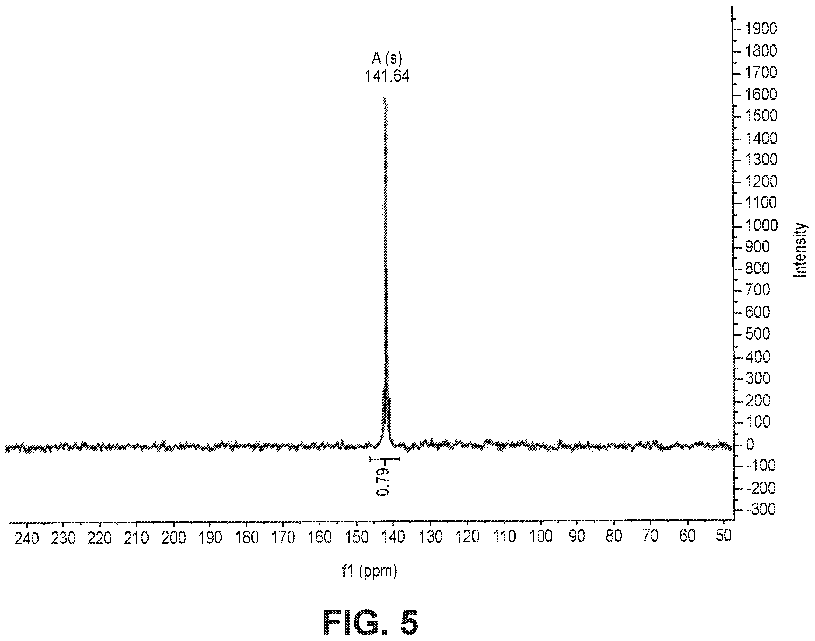

Fig. 5 shows the ¹¹⁹Sn NMR spectrum of (C₄H₇Sn)₄S₆ in chloroform-d. The spectrum shows a single peak at -141.64 ppm, corresponding to the four (4) tin atoms in equivalent bonding environments. The chloroform-d solvent had a resonance at -149 MHz.

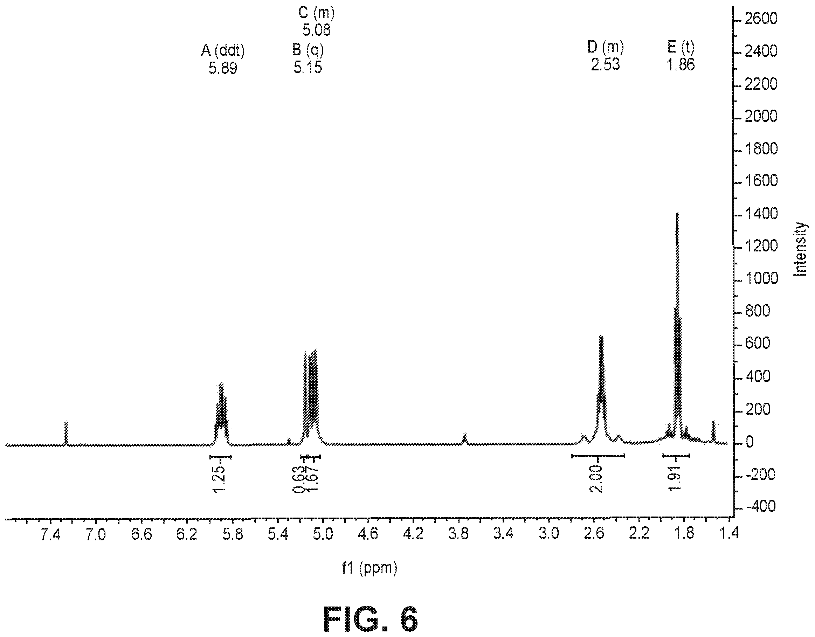

Fig. 6 shows the ¹H NMR spectrum of (C₄H₇Sn)₄S₆ in chloroform-d. The spectrum shows a ddt pattern (*J* = 16.6, 10.1, 6.3 Hz) at -5.89 ppm corresponding to one of the =CH₂ hydrogens of each of the four (4) the butenyl ligands. The spectrum also shows a multiplet at - 5.12 to -5.04 ppm corresponding to the other =CH₂ hydrogen of each of the four (4) the butenyl ligands. The spectrum shows a quartet (*J =* 1.6 Hz) at -5.15 ppm, corresponding to the four =CH hydrogens. The spectrum shows a multiplet between -2.79 and -2.32 ppm and a triplet (*J* = 7.8 Hz), each pattern corresponding to eight (8) -CH₂- hydrogens and showing an integration of 1:1. The chloroform-d solvent had a resonance at -400 MHz.

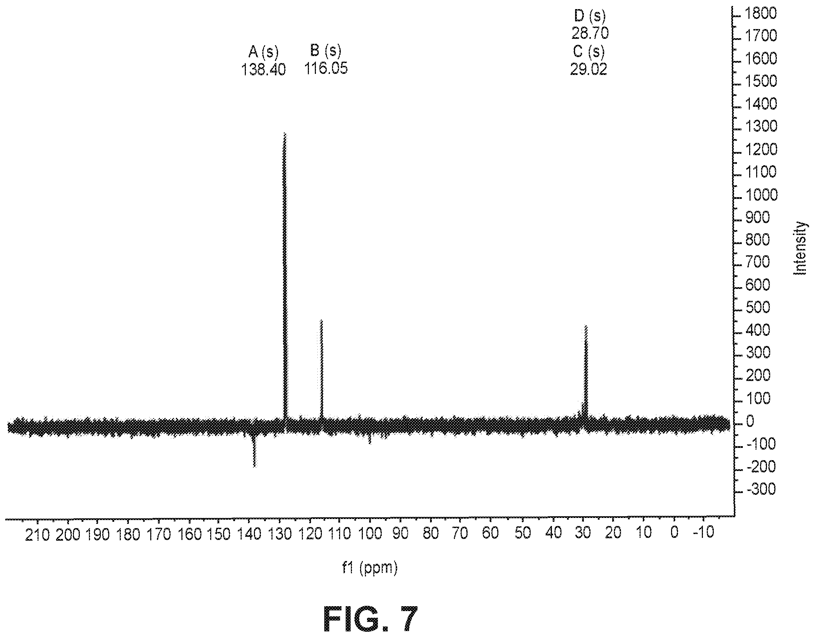

Fig. 7 shows the ¹³C NMR spectrum of (C₄H₇Sn)₄S₆ in benzene-d₆. The spectrum shows a singlet at -138.40 ppm, corresponding to the =CH carbon of the butenyl ligand. A singlet at -116.05 ppm corresponds to the =CH₂ carbon. Singlets at -29.02 ppm and -28.70 ppm correspond to the bonding environments of the two -CH₂- carbons. The benzene-d₆ solvent had a resonance at -101 MHz.

The characterization confirmed the synthesis of a purified n-butenyltin cluster composition product, R2.

### Example 3. Preparation of Precursor Solutions of (C₄H₉Sn)₄S₆ and (C₄H₇Sn)₄S₆

This example presents the preparation of precursor solutions with either an n-butyltin cluster composition or an n-butenyltin cluster composition. The solutions were prepared with one of six solvents and a range of tin concentrations.

A photoresist precursor solution was prepared by adding 0.17 g of (C₄H₉Sn)₄S₆ from Example 1 to 20 mL of toluene. The mixture was gently heated to form a stable, homogeneous solution that was visibly clear and transparent. Diagnostic ¹H and ¹¹⁹Sn NMR resonances show that the solution contains the tetramer (n-butylSn)₄S₆. Additional toluene solutions with tin concentrations between 64 and 288 mM were readily prepared by this method. Solutions were also prepared in a similar manner with the solvents THF, chlorobenzene, 1,1,2-trichloroethane, perfluorobenzene, and pentafluorobenzene. Tin concentrations in these solutions range from 1 to 150 mM.

A photoresist precursor solution was prepared by adding 0.17 g of (C₄H₇Sn)₄S₆ from Example 2 to 20 mL of toluene. The mixture was gently heated to form a clear solution. The solution remained clear through all periods preceding film deposition. Diagnostic ¹H and ¹¹⁹Sn NMR resonances show that the solution contains the tetramer (n-butenylSn)₄S₆. Additional toluene solutions with tin concentrations between 64 and 288 mM were readily prepared by this method. Solutions were also prepared in a similar manner with the solvents THF, chlorobenzene, 1,1,2-trichloroethane, perfluorobenzene, and pentafluorobenzene. Tin concentrations in these solutions range from 1 to 150 mM.

### Example 4. Film-Coated Wafers

This example describes the preparation of film-coated wafers and demonstrates that thin and smooth films can be deposited for both the n-butyltin and the n-butenyltin cluster compositions.

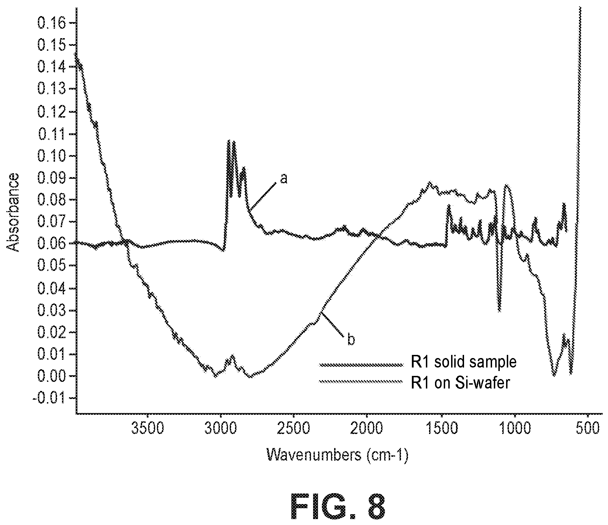

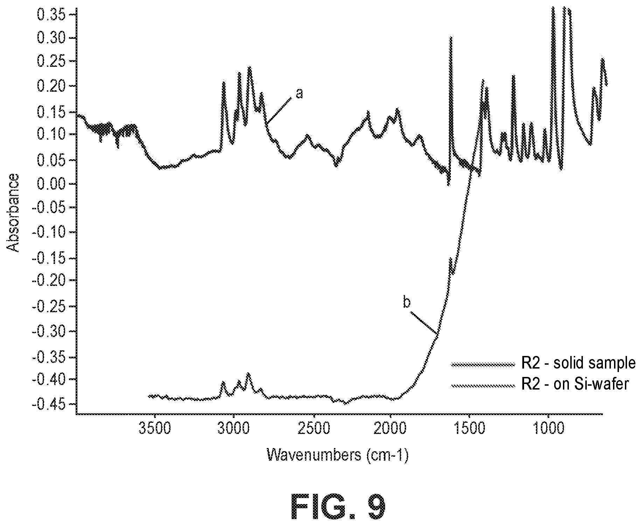

Silicon wafers (10.2-cm diameter) with a native-oxide surface served as substrates for thin-film deposition. Unless otherwise indicated, films were deposited on untreated wafers by spin coating toluene-based precursor solutions, prepared as described in Example 3, onto untreated wafers at 1500 rpm for 30 seconds. In some cases, wafers were pre-treated by wetting with casting solvent if useful to obtain a good coating. Specifically, a precursor solution of (C₄H₉Sn)₄S₆ (R1) in toluene having a tin concentration of 75 mM was spin coated onto a wafer at 1500 rpm for 30 seconds to produce a film sample (F1) with a film of thickness 176 nm. A second precursor solution of (C₄H₇Sn)₄S₆ (R2) in toluene having a tin concentration of 75 mM was spin coated onto a wafer at 1500 rpm for 30 seconds to produce a film sample with a film sample (F2) of thickness 188 nm. Fig. 8 shows FTIR spectra for a powder of R1, curve a, and the film sample F1, curve b. The results show the retention of the characteristic alkane C-H stretching absorptions at 3000-2850 cm⁻¹ and bending absorptions at 1470-1450 cm-1. However, the film showed different absorption in the range of 1600 to 500 cm⁻¹, suggesting spatial modifications to the structure of the Sn-S cage. Fig. 9 shows FTIR spectra for a powder of R2, curve a, and the film sample F2, curve b. The results show the retention of the characteristic alkane and alkene C-H stretching absorptions between 3100-2850 cm⁻¹.

A wafer coated with a 23.68-nm thick film of (C₄H₉Sn)₄S₆ showed a root-mean-square surface roughness of 0.7 nm, as determined by atomic-force microscopy. Similarly, a wafer coated with a 21.1-nm thick film of (C₄H₇Sn)₄S₆ showed a surface roughness of 0.4 nm. These results indicate that the tin cluster compositions can be deposited as a relatively smooth film.

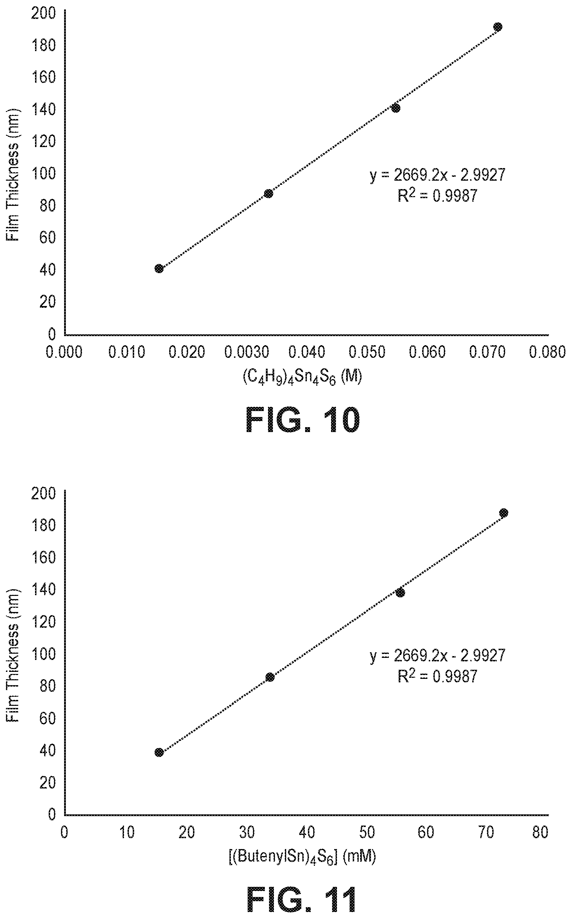

A set of film samples was prepared from precursor solutions of toluene with various concentrations of (C₄H₉Sn)₄S₆ cluster composition. Fig. 10 shows the linear dependence of film thickness on the concentration of R1. A second set of film samples was prepared from precursor solutions of toluene with various concentrations of (C₄H₇Sn)₄S₆ cluster composition. Fig. 11 shows the linear dependence of film thickness on the concentration of R2. These results indicate that the tin cluster compositions can be deposited at a well-controlled thickness at a nanometer scale.

### Example 5. Negative Tone Imaging with UV Exposure

This example demonstrates that UV radiation can induce negative tone dissolution contrast in films prepared from n-butyltin and n-butenyltin cluster compositions.

Film samples F1 and F2, prepared as described in Example 4, were placed in a box lined with aluminum foil within an argon-filled glovebox. Sections of film samples F1 and F2 were exposed to laboratory UV light to provide radiation at a wavelength of around 354 nm for some minutes for all of the samples uniformly to provide an appropriate dose, resulting in film samples F1 and F2 each having regions of exposed and unexposed film. The film samples were then developed by submerged for 30 seconds in a mixture of anisole and THF. For each anisole:THF mixture, the film thickness was measured for the exposed and unexposed sections of each film sample using a J. A. Woollam M-2000 spectroscopic ellipsometer. The normalized film thickness was calculated as the thickness of the developed section divided by the average thickness of the film prior to the development step.

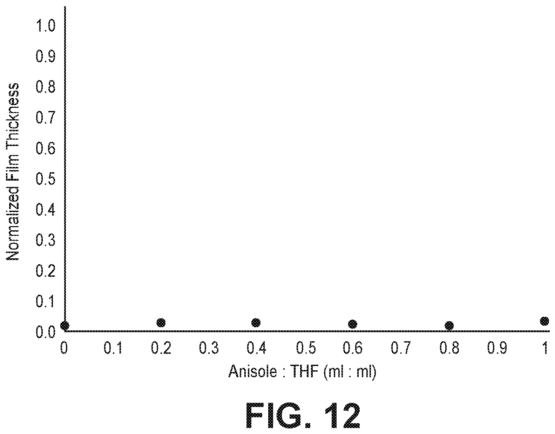

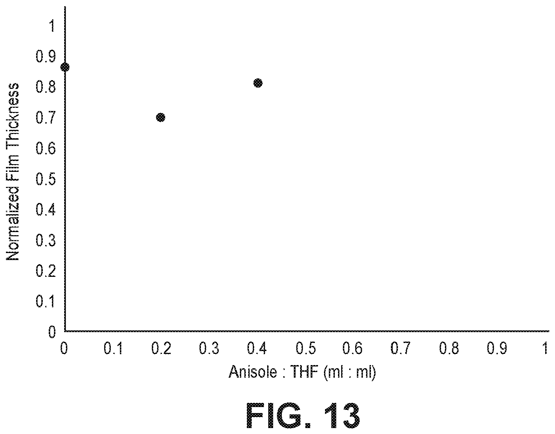

Fig. 12 shows the normalized film thickness of the unexposed section of film F1 as a function of the volumetric fraction of anisole in THF. The plot shows that the unexposed film of (C₄H₉Sn)₄S₆ dissolves fully in each developer composition after 30 seconds. Fig. 13 shows the normalized film thickness of the UV-exposed section of film F1 as a function of the volumetric fraction of anisole in THF. The plot shows that after the 30 second development, more than 70% of the film thickness remains. The data indicate that a change in dissolution rate occurs after UV exposure, i.e., the UV exposure induces a chemical change and produces a latent image.

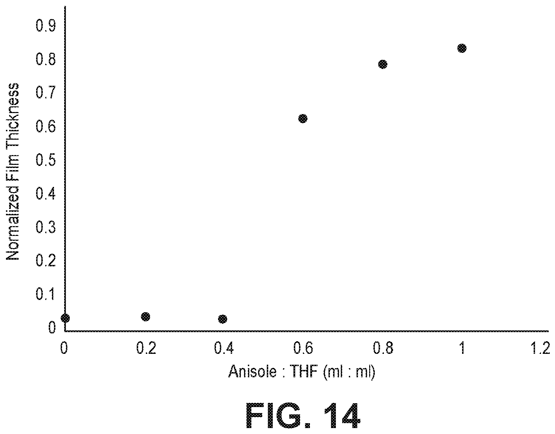

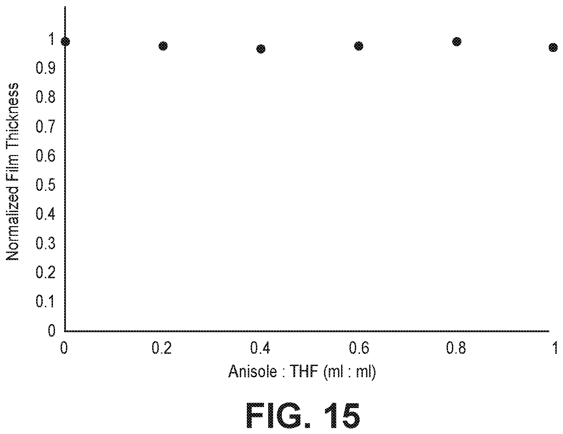

Fig. 14 shows the normalized film thickness of the unexposed section of film F2 as a function of the volumetric fraction of anisole in THF. The plot shows that unexposed films of (C₄H₇Sn)₄S₆ dissolve in 0 - 40 % anisole in THF. Between 60 and 100 vol% anisole, the dissolution of the unexposed R2 composition decreased with increasing volume percent of anisole. Fig. 15 shows the normalized film thickness of the UV-exposed section of film F2 as a function of the volumetric fraction of anisole in THF. The plot shows that exposed films of (C₄H₇Sn)₄S₆ retain 97-99% of the original thickness in all of the developer compositions tested.

All these data demonstrate that UV exposure of (C₄H₉Sn)₄S₆ and (C₄H₇Sn)₄S₆ films produces chemical changes that alter the dissolution rate. Exposure and subsequent dissolution in the mixed solutions of anisole and THF reveal that the films are negative-tone photoresists.

### Example 6. Solubility Contrast via EUV exposure

This example demonstrates solubility contrast in films from Example 3 after exposure to EUV radiation.

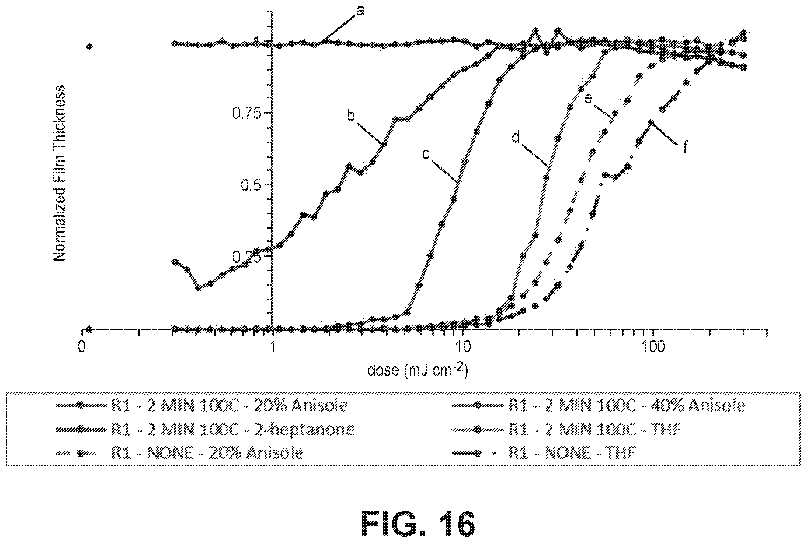

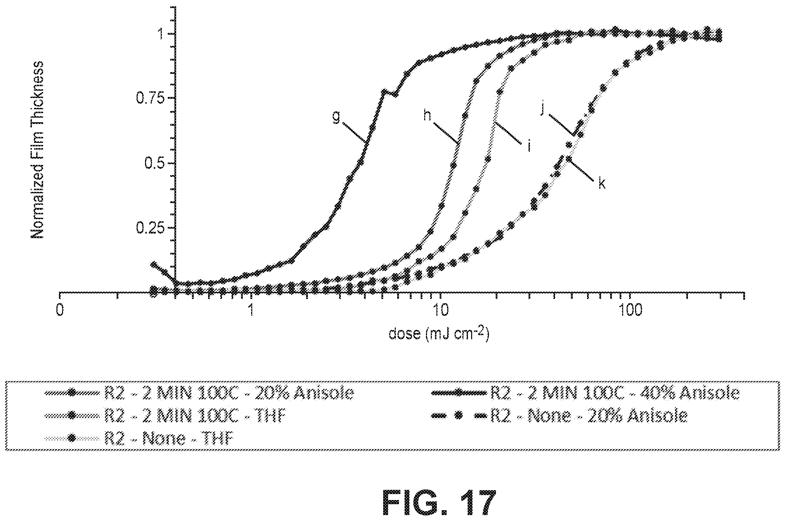

Films were deposited as described in Example 4 onto 10.2-cm diameter silicon wafers with a native oxide surface. Precursor solutions of (C₄H₉Sn)₄S₆ and (C₄H₇Sn)₄S₆ were prepared with a concentration suitable to deposit films of R1 and R2, respectively, each film with a thickness of approximately 20 nm. For the contrast curves shown in Fig. 16 and Fig. 17, film thickness ranged between 20.6 nm and 22.9 nm.

Films were exposed on the EUV Direct Contrast Tool at Lawrence Berkeley National Laboratory. Prior to exposure, the films were baked at 100 °C for 2 minutes. A linear array of 50 circular exposure regions ~500 µm in diameter were projected onto the wafer with increasing EUV exposure doses. After exposure, the films were developed with 2-heptanone, THF, a 20% (v/v) mixture of anisole in THF, or a 40% (v/v) mixture of anisole in THF. Films were developed either with or without a post-exposure bake at 100 °C for 2 minutes. The thickness of each exposed pad was assessed with a J. A. Woollam M-2000 spectroscopic ellipsometer. The normalized thickness of each pad is plotted as a function of EUV dose in Figs. 16 and 17 for various process conditions (curves a-k). In unexposed and low-dose regions, the normalized film thickness is near 0. The curves rise to a maximum (dose to gel, D_{g}) above 7 mJ cm⁻² for each film showing the combined effect of exposure dose and developer composition on the solubility contrast.

Table 1 summarizes process conditions, developer composition, and derived results (Dₒ, Dg, and contrast) for each composition (C₄H₉Sn)₄S₆ (R1) and (C₄H₇Sn)₄S₆ (R2). Curves a-k are shown in Figs. 16 and 17.

**TABLE 1**

| ***Precursor*/ *Curve*** | ***Bake* (°C/ min)** | ***Developer*** | ***D_{g}*** | ***Dₒ*** | ***Contrast Value*** |
|---|---|---|---|---|---|
| R1/c | 100 / 2 | 20 % Anisole in THF | 16.8 | 5.1 | 1.9 |
| R1/b | 100 / 2 | 40 % Anisole in THF | 7.6 | 0.8 | 1 |
| R1/a | 100 / 2 | 2-heptanone | 45.1 | 0 | 0.1 |
| R1/d | 100 / 2 | THF | 40.6 | 17.6 | 2.8 |
| R1/e | No Bake | 20 % Anisole in THF | 80.1 | 20.6 | 1.7 |
| R1/f | No Bake | THF | 124.6 | 26.7 | 1.5 |
| R2/h | 100 / 2 | 20 % Anisole in THF | 17.9 | 7.9 | 2.8 |
| R2/g | 100 / 2 | 40 % Anisole in THF | 7.8 | 1.8 | 1.6 |
| R2/NA | 100 / 2 | 2-heptanone | - | - | - |
| R2/i | 100 / 2 | THF | 25.8 | 12.3 | 3.1 |
| R2/j | No Bake | 20 % Anisole in THF | 98.2 | 18.6 | 1.4 |
| R2/k | No Bake | THF | 99.0 | 22.3 | 1.5 |

The results show that EUV exposure of (C₄H₉Sn)₄S₆ and (C₄H₇Sn)₄S₆ films produces chemical changes that alter the dissolution rate. Exposure and subsequent processing show that good solubility contrast can be achieved for compositions R1 and R2. For the process conditions tested, the highest contrast was achieved with development in THF after a bake step. In the absence of a bake step, the 20% (v/v) anisole in THF provided better contrast than THF for the R1 composition. In the case of the R2 composition without a bake step, the THF developer provided the better contrast.

The embodiments above are intended to be illustrative and not limiting. Additional embodiments are within the claims. In addition, although the present invention has been described with reference to particular embodiments, those skilled in the art will recognize that changes can be made in form and detail without departing from the scope of the invention as defined in the claims.

## Claims

1. A structure with a radiation sensitive patterning layer comprising a substrate and a radiation sensitive layer comprising organotin clusters represented by the formula (RSn)₄X₆ wherein R is an organic ligand bound to Sn with a metal-carbon bond, and X is S or Se wherein the radiation sensitive layer has an average thickness from 2 nm to a micrometer, wherein the organic ligand has 1 to 15 carbon atoms.

2. The structure of claim 1 wherein R is an alkyl group, an alkenyl group, an aryl group or combinations thereof.

3. The structure of claim 1 wherein the organotin clusters comprise n-butyl tin sulfide, n-butenyl tin sulfide, or combinations thereof.

4. The structure of any one of claims 1 through 3 wherein the radiation sensitive layer has an average thickness of 2 nm to 200 nm.

5. The structure of any one of claims 1 through 4 wherein the thickness of the layer at any point across the structure varies by no more than 25% from the average thickness of the layer.

6. The structure of any one of claims 1 through 5 wherein the radiation sensitive patterning layer comprises a material with a virtual image corresponding to a selected pattern of radiation, wherein the virtual image has regions with different solubility to an organic solvent.

7. The structure of claim6 wherein the material has regions of irradiated coating material comprising crosslinked organotin clusters.

8. The structure of any one of claims 1 through 7 wherein the substrate comprises a silicon wafer.

9. A patterning precursor solution comprising:
an organic solvent; and
an organotin cluster composition represented by the formula (RSn)₄X₆ where R is an organic ligand bound to Sn with a metal-carbon bond and X is S or Se, wherein the organic ligand has 1 to 15 carbon atoms, and wherein the precursor solution has a concentration based on tin from 0.0005M to 1M.

10. The patterning precursor solution of claim 9 wherein the precursor solution has a concentration based on tin from 0.0025M to 0.4M and wherein the organic solvent comprises benzene; toluene; 1,1,2-trichloroethane; chloroform; tetrahydrofuran (THF); anisole; derivatives thereof; or combinations thereof.

11. The patterning precursor solution of claim 9 or claim 10 wherein the organotin cluster composition comprises n-butyl tin sulfide, n-butenyl tin sulfide, or combinations thereof.

12. A method for forming a radiation sensitive layer suitable for patterning on a substrate surface, the method comprising:
depositing (RSn)₄X₆ clusters onto a substrate, where X is S or Se and R is an organic ligand bound to Sn with a metal-carbon bond, wherein the organic ligand has 1 to 15 carbon atoms, and wherein the depositing comprises:
1) contacting a solution comprising (RSn)₄S₆ clusters and an organic solvent with the substrate surface, and
removing the solvent to form a layer of a radiation sensitive coating material;
2) volatilizing the (RSn)₄X₆ clusters, and
collecting the volatilized clusters on the substrate surface; or
3) performing a reactive deposition of (RSn)₄X₆ using a vapor of (RSn)₄Y₆ and gaseous H₂X, where Y is a halogen atom.

13. The method of claim 12 wherein the organic solvent comprises benzene; toluene; 1,1,2-trichloroethane; chloroform; tetrahydrofuran (THF); anisole; derivatives thereof; or combinations thereof.

14. The method of claim 12 wherein the depositing comprises vapor deposition or spin coating.

15. The method of claim 12 wherein the solution has a concentration of tin atoms from 0.0005M to 1M.

## Patentansprüche

1. Struktur mit einer strahlungsempfindlichen Strukturierungsschicht, umfassend ein Substrat und eine strahlungsempfindliche Schicht, umfassend Organozinn-Cluster, die durch die Formel (RSn)₄X₆ wiedergegeben werden, wobei R ein organischer Ligand ist, der mit einer Metall-Kohlenstoff-Bindung an Sn gebunden ist, und X S oder Se ist, wobei die strahlungsempfindliche Schicht eine durchschnittliche Dicke von 2 nm bis einem Mikrometer aufweist, wobei der organische Ligand 1 bis 15 Kohlenstoffatome aufweist.

2. Struktur nach Anspruch 1, wobei R eine Alkylgruppe, eine Alkenylgruppe, eine Arylgruppe oder Kombinationen davon ist.

3. Struktur nach Anspruch 1, wobei die Organozinn-Cluster n-Butylzinnsulfid, n-Butenylzinnsulfid oder Kombinationen davon umfassen.

4. Struktur nach einem der Ansprüche 1 bis 3, wobei die strahlungsempfindliche Schicht eine durchschnittliche Dicke von 2 nm bis 200 nm aufweist.

5. Struktur nach einem der Ansprüche 1 bis 4, wobei die Dicke der Schicht an jedem Punkt über die Struktur um nicht mehr als 25 % von der durchschnittlichen Dicke der Schicht variiert.

6. Struktur nach einem der Ansprüche 1 bis 5, wobei die strahlungsempfindliche Strukturierungsschicht ein Material mit einem virtuellen Bild umfasst, welches einem ausgewählten Strahlungsmuster entspricht, wobei das virtuelle Bild Regionen mit unterschiedlicher Löslichkeit in einem organischen Lösungsmittel aufweist.

7. Struktur nach Anspruch 6, wobei das Material Regionen aus bestrahltem Beschichtungsmaterial aufweist, umfassend vernetzte Organozinn-Cluster.

8. Struktur nach einem der Ansprüche 1 bis 7, wobei das Substrat einen Silicium-Wafer umfasst.

9. Strukturierungsvorläuferlösung, umfassend:
ein organisches Lösungsmittel; und
eine Organozinn-Clusterzusammensetzung, die durch die Formel (RSn)₄X₆ wiedergegeben wird, wobei R ein organischer Ligand ist, der mit einer Metall-Kohlenstoff-Bindung an Sn gebunden ist, und X S oder Se ist, wobei der organische Ligand 1 bis 15 Kohlenstoffatome aufweist, und wobei die Vorläuferlösung eine auf Zinn basierte Konzentration von 0,0005 M bis 1 M aufweist.

10. Strukturierungsvorläuferlösung nach Anspruch 9, wobei die Vorläuferlösung eine auf Zinn basierte Konzentration von 0,0025 M bis 0,4 M aufweist, und wobei das organische Lösungsmittel Benzol; Toluol; 1,1,2-Trichlorethan; Chlorform; Tetrahydrofuran (THF); Anisol; Derivate davon oder Kombinationen davon umfasst.

11. Strukturierungsvorläuferlösung nach Anspruch 9 oder Anspruch 10, wobei die Organozinn-Clusterzusammensetzung n-Butylzinnsulfid, n-Butenylzinnsulfid oder Kombinationen davon umfasst.

12. Verfahren zum Bilden einer strahlungsempfindlichen Schicht, die zur Strukturierung auf einer Substratoberfläche geeignet ist, wobei das Verfahren umfasst:
Abscheiden von (RSn)₄X₆-Clustern auf einem Substrat, wobei X S oder Se ist, und R ein organischer Ligand ist, der mit einer Metall-Kohlenstoff-Bindung an Sn gebunden ist, wobei der organische Ligand 1 bis 15 Kohlenstoffatome aufweist, und wobei das Abscheiden umfasst:
1) Kontaktieren einer Lösung, umfassend (RSn)₄S₆-Cluster und ein organisches Lösungsmittel, mit der Substratoberfläche, und
Entfernen des Lösungsmittels, um eine Schicht eines strahlungsempfindlichen Beschichtungsmaterials zu bilden;
2) Verflüchtigen der (RSn)₄X₆-Cluster, und
Auffangen der verflüchtigten Cluster auf der Substratoberfläche; oder
3) Durchführen einer Reaktivabscheidung von (RSn)₄X₆ unter Verwendung eines Dampfes von (RSn)₄Y₆ und gasförmigem H₂X, wobei Y ein Halogenatom ist.

13. Verfahren nach Anspruch 12, wobei das organische Lösungsmittel Benzol; Toluol, 1,1,2-Trichlorethan; Chloroform; Tetrahydrofuran (THF); Anisol; Derivate davon oder Kombinationen davon umfasst.

14. Verfahren nach Anspruch 12, wobei die Abscheidung Gasphasenabscheidung oder Schleuderbeschichtung umfasst.

15. Verfahren nach Anspruch 12, wobei die Lösung eine Konzentration an Zinnatomen von 0,0005 M bis 1 M aufweist.

## Revendications

1. Structure avec une couche de formation de motifs sensible aux rayonnements comprenant un substrat et une couche sensible aux rayonnements comprenant des agrégats d'organoétain représentés par la formule (RSn)₄X₆, R étant un ligand organique lié à Sn avec une liaison métal-carbone, et X étant S ou Se, la couche sensible aux rayonnements ayant une épaisseur moyenne de 2 nm à un micromètre, le ligand organique ayant 1 à 15 atomes de carbone.

2. Structure selon la revendication 1, R étant un groupe alkyle, un groupe alcényle, un groupe aryle ou des combinaisons de ceux-ci.

3. Structure selon la revendication 1, les agrégats d'organoétain comprenant du sulfure de n-butylétain, du sulfure de n-buténylétain ou des combinaisons de ceux-ci.

4. Structure selon l'une quelconque des revendications 1 à 3, la couche sensible aux rayonnements ayant une épaisseur moyenne de 2 nm à 200 nm.

5. Structure selon l'une quelconque des revendications 1 à 4, l'épaisseur de la couche en un point quelconque à travers la structure ne variant pas de plus de 25 % par rapport à l'épaisseur moyenne de la couche.

6. Structure selon l'une quelconque des revendications 1 à 5, la couche de formation de motifs sensible aux rayonnements comprenant un matériau avec une image virtuelle correspondant à un motif sélectionné de rayonnement, l'image virtuelle ayant des régions avec une solubilité différente par rapport à un solvant organique.

7. Structure selon la revendication 6, le matériau ayant des régions de matériau de revêtement irradié comprenant des agrégats d'organoétain réticulé.

8. Structure selon l'une quelconque des revendications 1 à 7, le substrat comprenant une tranche de silicium.

9. Solution de précurseur de formation de motifs comprenant :
un solvant organique ; et
une composition d'agrégats d'organoétain représentée par la formule (RSn)₄X₆, R étant un ligand organique lié à Sn avec une liaison métal-carbone et X étant S ou Se, le ligand organique ayant 1 à 15 atomes de carbone, et la solution de précurseur ayant une concentration basée sur l'étain de 0,0005 M à 1 M.

10. Solution de précurseur de de formation de motifs selon la revendication 9, la solution de précurseur ayant une concentration basée sur l'étain de 0,0025 M à 0,4 M et le solvant organique comprenant du benzène ; du toluène ; du 1,1,2-trichloroéthane ; du chloroforme ; du tétrahydrofuranne (THF) ; de l'anisole ; leurs dérivés ; ou leurs combinaisons.

11. Solution de précurseur de de formation de motifs selon la revendication 9 ou la revendication 10, la composition d'agrégats d'organoétain comprenant du sulfure de n-butylétain, du sulfure de n-buténylétain ou leurs combinaisons.

12. Procédé de formation d'une couche sensible aux rayonnements appropriée pour la formation de motifs sur une surface de substrat, le procédé comprenant :
le dépôt d'agrégats (RSn)₄X₆ sur un substrat, X étant S ou Se et R étant un ligand organique lié à Sn avec une liaison métal-carbone, le ligand organique ayant 1 à 15 atomes de carbone, et le dépôt comprenant :
1) la mise en contact d'une solution comprenant des agrégats (RSn)₄S₆ et d'un solvant organique avec la surface du substrat, et
l'élimination du solvant pour former une couche de matériau de revêtement sensible aux rayonnements ;
2) la volatilisation des agrégats (RSn)₄X₆, et
le recueil des agrégats volatilisés à la surface du substrat ; ou
3) la réalisation d'un dépôt réactif de (RSn)₄X₆ en utilisant une vapeur de (RSn)₄Y₆ et de H₂X gazeux, Y étant un atome d'halogène.

13. Procédé selon la revendication 12, le solvant organique comprenant du benzène ; du toluène ; du 1,1,2-trichloroéthane ; du chloroforme ; du tétrahydrofuranne (THF) ; de l'anisole ; leurs dérivés ; ou leurs combinaisons.

14. Procédé selon la revendication 12, le dépôt comprenant un dépôt en phase vapeur ou un revêtement par centrifugation.

15. Procédé selon la revendication 12, la solution ayant une concentration en atomes d'étain de 0,0005 M à 1 M.
